Europäisches Patentamt

European Patent Office

Office européen des brevets

(11) Publication number: **0 161 446**
A2

# EUROPEAN PATENT APPLICATION

(21) Application number: 85103819.0

(22) Date of filing: 29.03.85

(51) Int. Cl.⁴: **H 01 L 27/02,** H 01 L 27/08, H 01 L 29/08
// G11C17/00

(30) Priority: 31.03.84 JP 63686/84

(43) Date of publication of application: 21.11.85
Bulletin 85/47

(84) Designated Contracting States: DE FR GB

(71) Applicant: Kabushiki Kaisha Toshiba, 72, Horikawa-cho
Saiwai-ku, Kawasaki-shi Kanagawa-ken 210 (JP)

(72) Inventor: Tanaka, Sumio c/o Patent Division, Kabushiki
Kaisha Toshiba 1-1 Shibaura 1-chome, Minato-ku
Tokyo 105 (JP)
Inventor: Atsumi, Shigeru c/o Patent Division, Kabushiki
Kaisha Toshiba 1-1 Shibaura 1-chome, Minato-ku
Tokyo 105 (JP)
Inventor: Tozawa, Noriyoshi c/o Patent Division,
Kabushiki Kaisha Toshiba 1-1 Shibaura 1-chome,
Minato-ku Tokyo 105 (JP)
Inventor: Tsushima, Toshiki c/o Patent Division,
Kabushiki Kaisha Toshiba 1-1 Shibaura 1-chome,
Minato-ku Tokyo 105 (JP)
Inventor: Okuda, Taizo c/o Patent Division, Kabushiki
Kaisha Toshiba 1-1 Shibaura 1-chome, Minato-ku
Tokyo 105 (JP)
Inventor: Asano, Masamichi c/o Patent Division,
Kabushiki Kaisha Toshiba 1-1 Shibaura 1-chome,
Minato-ku Tokyo 105 (JP)

(74) Representative: Lehn, Werner, Dipl.-Ing. et al, Hoffmann,
Eitle & Partner Patentanwälte
Arabellastrasse 4 (Sternhaus), D-8000 München 81 (DE)

(54) Semiconductor integrated circuit comprising a protective transistor and a MOS transistor with an LDD structure.

(57) A protective MOS transistor (Q1) having a parasitic
bipolar transistor for discharging to the groud (Vss) an
electric charge generated in the semiconductor substrate
(19) by application of a surge voltage to a high voltage
power supply terminal (18) is provided between the ground
(Vss) and the high voltage power supply terminal (18) of a
semiconductor integrated circuit (16) including a MOS tran-
sistor with an LDD structure. The protective MOS transistor
(Q1) is formed on the same semiconductor substrate (19) as
the semiconductor integrated circuit (16).

- 1 -

Semiconductor integrated circuit device including
a MOS transistor with an LDD structure

The present invention relates to a semiconductor integrated circuit device including a MOS transistor having an LDD structure and, more particularly, to a device for protecting such a MOS transistor from a surge voltage applied to a semiconductor integrated circuit device.

As a conventional MOS transistor having a high withstand voltage, one having a so-called LDD structure is well known and is described in, e.g., IEEE JOURNAL OF SOLID-STATE CIRCUIT, VOL. SC-15, No. 4, AUGUST 1980, "Design and Characteristics of the Lightly Doped Drain-Source (LDD) Insulated Gate Field-Effect Transistor" by SEIKI OGURA et al.

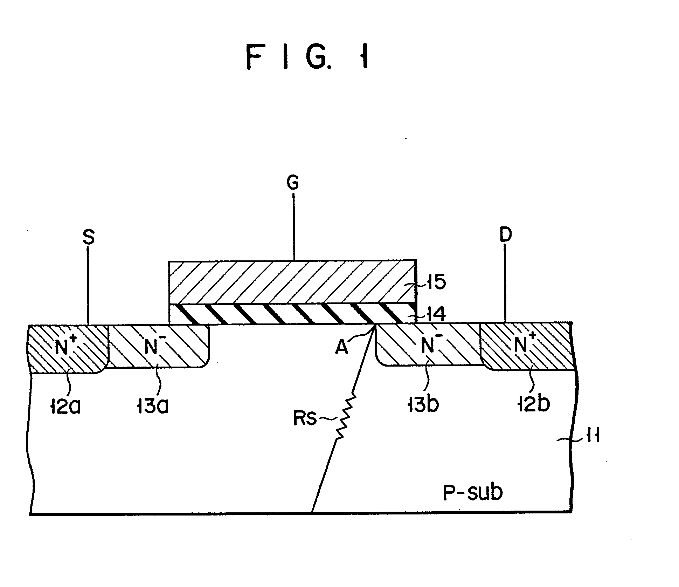

Fig. 1 shows a structure of a MOS transistor having an LDD structure, in which $n^+$-type impurity diffusion regions 12a and 12b respectively serving as a source S and a drain D are formed in a major surface region of a p-type semiconductor substrate 11. These impurity diffusion regions 12a and 12b have an impurity concentration of about $1 \times 10^{20}$ $cm^{-3}$ and $n^-$-type impurity diffusion regions 13a and 13b for increasing a surface junction withstand voltage are provided between the impurity diffusion regions 12a and 12b, so that one end of each of the regions 13a and 13b contacts the regions 12a and 12b, respectively. These impurity diffusion regions 13a and 13b have an impurity concentration of about $1 \times 10^{17}$ cm$^{-3}$ to $1 \times 10^{18}$ cm$^{-3}$. A gate insulating film 14, e.g., a silicon oxide film having a thickness of 500 Å is formed on the major surface of the semiconductor substrate 11 between the impurity diffusion regions 13a and 13b. A gate electrode 15 is formed on the gate insulating film 14. In a normal circuit, a MOS transistor is coupled to the source S side so as to increase the resistance thereof.

When a positive surge voltage is applied upon the drain D of the MOS transistor with the structure shown in Fig. 1, an electric field at an interface A between the n$^-$-type impurity diffusion region 13a and the surface of the semiconductor substrate 11 is strong, thus causing an avalanche breakdown. In this case, the avalanche breakdown occurs locally. Substrate resistance Rs of the semiconductor substrate 11 is increased by the avalanche breakdown. For example, when the substrate 11 normally has a resistance of, e.g., 20 Ωcm, it is increased to about 1 to 2 kΩ. Since a breakdown voltage at the interface A is high because of a high withstand voltage structure in addition to the high resistances of the semiconductor substrate 11 and the source S, no path for absorbing the positive surge voltage is present. For this reason, a voltage at the interface A is higher than that of the gate (e.g., ground level), and the gate oxide film 14 easily breaks down. This phenomenon frequently occurs in a MOS transistor having an LDD structure which is micropatterned according to a reduction rule and has a thin gate oxide film.

It is, therefore, an object of the present invention to provide a semiconductor integrated circuit device including a MOS transistor with an LDD structure in which the surge withstand voltage is increased.

According to an embodiment of the present invention, there is provided a semiconductor integrated circuit device comprising a semiconductor integrated circuit including a MOS transistor of an LDD structure, and a protective transistor consisting of a parasitic transistor, which is provided between a power supply terminal and the ground of the semiconductor integrated circuit, for discharging an electric charge generated by the application of a surge voltage to the semiconductor integrated circuit.

With this arrangement, an electric charge generated by the application of a surge voltage to the semiconductor integrated circuit can be quickly discharged by utilizing a bipolar operation caused by the avalanche junction breakdown of a parasitic transistor whose emitter and base are both grounded, thus improving the surge withstand voltage of the MOS transistor with an LDD structure.

This invention can be more fully understood from the following detailed description when taken in conjunction with the accompanying drawings, in which:

Fig. 1 is a sectional view of a MOS transistor having an LDD structure;

Fig. 2 is a block diagram for explaining a semiconductor integrated circuit device including a MOS transistor having an LDD structure according to an embodiment of the present invention;

Fig. 3 is a block diagram showing an arrangement of a write circuit in the device shown in Fig. 2;

Fig. 4 is a sectional view showing an arrangement of a protective MOS transistor in the device shown in Fig. 2;

Figs. 5 and 6 are sectional views showing other arrangements of protective MOS transistors in the device shown in Fig. 2;

Fig. 7 is a graph for explaining the relationship between a channel width and a withstand voltage of the protective MOS transistor in the device of Fig. 2; and

Figs. 8 and 9 are block diagrams for explaining other embodiments of the present invention.

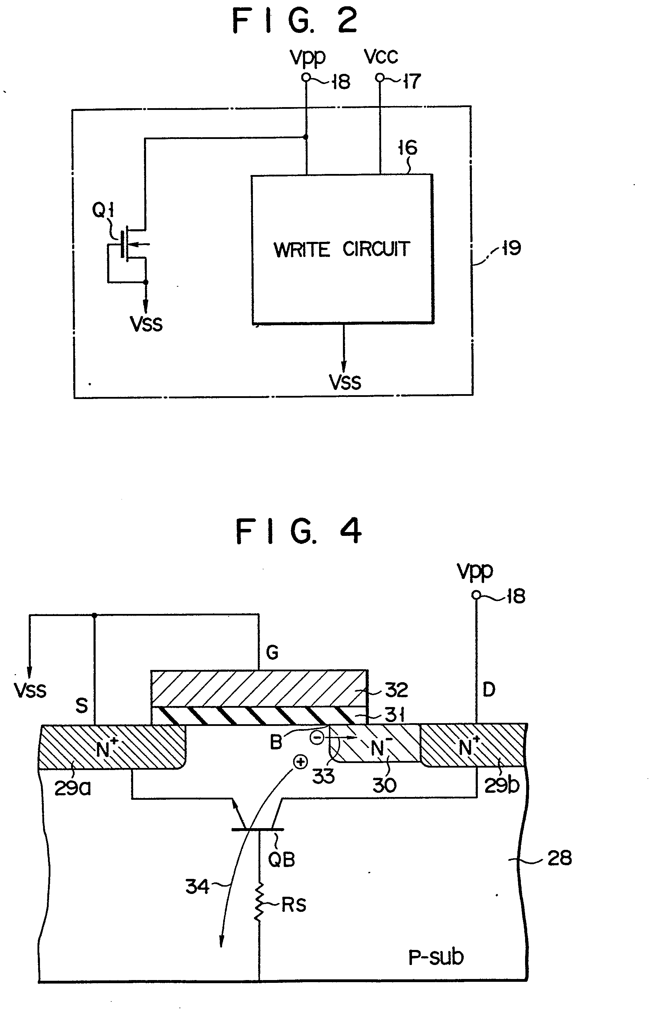

Fig. 2 shows a semiconductor integrated circuit device including a MOS transistor having an LDD structure according to an embodiment of the present invention. Note that in this embodiment, a peripheral circuit (write circuit) of an EPROM will be described. In this EPROM, an LDD structure is used in n- and p-channel MOS transistors to which a high voltage is applied. An operating power supply voltage Vcc from a power supply terminal 17, a high voltage power supply voltage Vpp for data write from a high voltage power supply terminal 18, and a power supply voltage Vss are respectively supplied to a write circuit 16. A protective MOS transistor Q1 is connected between the high voltage power supply terminal 18 and the power supply Vss (ground), and the gate thereof is connected to ground Vss. The write circuit 16 and the protective MOS transistor Q1 are formed on a single semiconductor substrate 19. Therefore, the write circuit 16 and the protective MOS transistor Q1 can be simultaneously formed with the same process.

With the above arrangement, an electric charge generated in the semiconductor substrate 19 by a surge voltage applied to the high voltage power supply terminal 18 can be quickly bypassed to the ground Vss using the protective MOS transistor Q1. Therefore, a high voltage will be applied to the high voltage power supply terminal 18 for a long period of time.

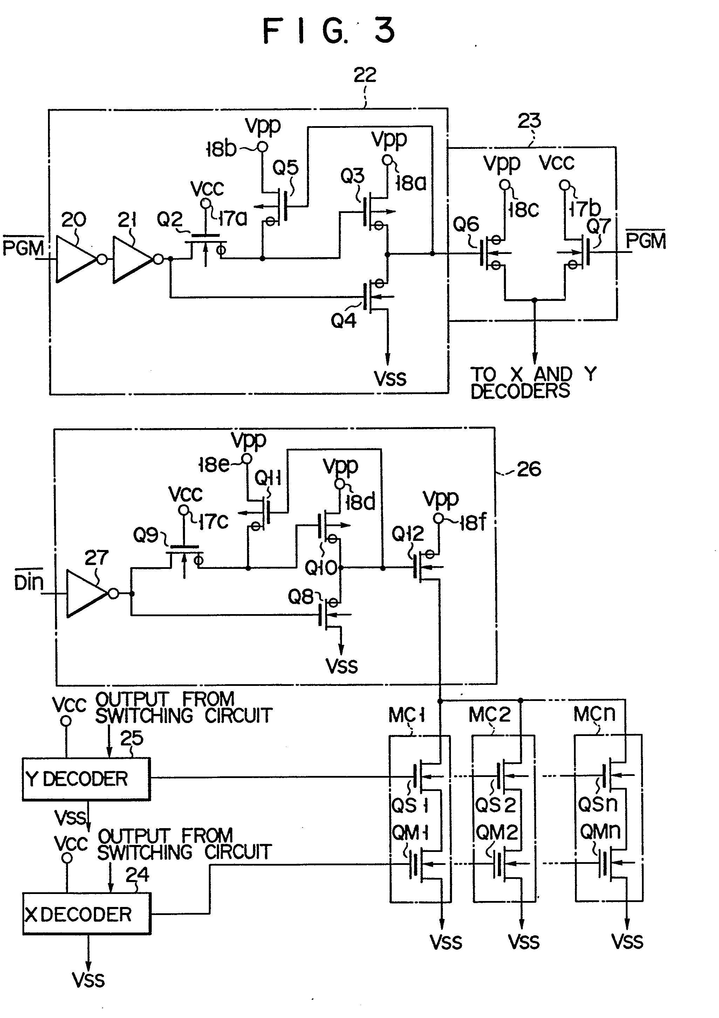

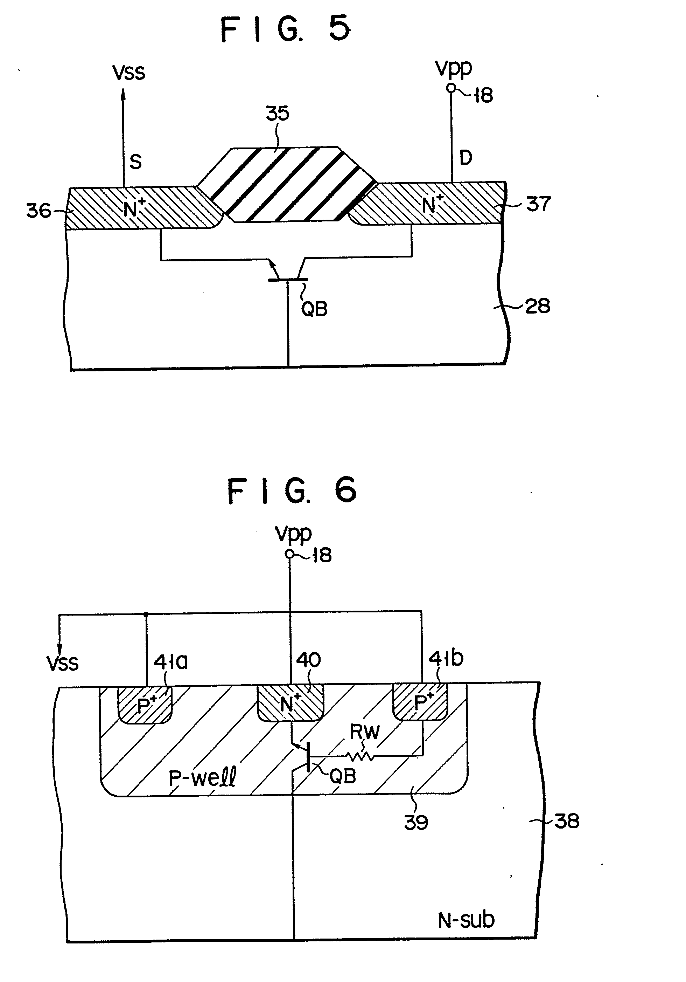

The present invention will be described in detail with reference to circuit arrangements shown in Figs. 3 and 4.

Fig. 3 shows an arrangement of the write circuit in the device of Fig. 2. In Fig. 3, MOS transistors having the source and drain marked with circles have the LDD structure shown in Fig. 1. MOS transistors having either the source or drain marked with a circle have the LDD structure in which either the low impurity diffusion layer 13a or 13b in Fig. 1 is formed.

An output terminal of an inverter 20 to which a write control signal $\overline{PGM}$ is supplied is connected to an input terminal of an inverter 21. An output terminal of the inverter 21 is connected to the gate of a p-channel MOS transistor Q3 through an n-channel MOS transistor Q2. The gate of the MOS transistor Q2 is connected to a power supply terminal 17a to which the operating power supply voltage Vcc is supplied. One end of the MOS transistor Q3 is connected to a high voltage power supply terminal 18a to which the high voltage power supply voltage Vpp is supplied, and the other end thereof is connected to one end of a MOS transistor Q4. The other end of the MOS transistor Q4 is connected to the ground Vss, and the gate thereof is connected to the output terminal of the inverter 21. A p-channel MOS transistor Q5 is connected between the gate of the MOS transistor Q3 and a high voltage power supply terminal 18b to which the high voltage power supply voltage Vpp is supplied. The gate of the MOS transistor Q5 is connected to a node between the MOS transistors Q3 and Q4. Thus, a write control circuit 22 is constituted by the inverters 20 and 21 and the MOS transistors Q2 to Q5. An output of the write control circuit 22 obtained from the node between the MOS transistors Q3 and Q4 is supplied to the gate of an n-channel MOS transistor Q6 which constitutes a switching circuit 23. One end of the MOS transistor Q6 is connected to a high voltage power supply terminal 18c to which the high voltage power supply voltage Vpp is supplied, and the other end thereof is connected to one end of an n-channel MOS transistor Q7. The other end of the MOS transistor Q7 is connected to a power supply terminal 17b to which the operating power supply voltage Vcc is supplied, and the write control signal $\overline{PGM}$ is supplied to the gate thereof. An outut of the switching circuit 23 obtained from a node between the MOS transistors Q6 and Q7 is supplied to X and Y decoders 24 and 25. The X and Y decoders 24 and 25 are respectively operated by the power supply voltages Vcc and Vss. An output from the X decoder 24 is supplied to the respective gates of MOS transistors QM1, QM2, ..., QMn having a floating gate structure. On the other hand, an output from the Y decoder 25 is supplied to the respective gates of n-channel MOS transistors QS1, QS2, ..., QSn for selecting the floating gate MOS transistors QM1, QM2, ..., QMn. A memory cell MCx is constituted by the floating gate MOS transistor QMx (x = 1, 2, ..., n) and the selection MOS transistor QSx. A write signal is supplied to the memory cells MC1, MC2, ..., MCn from a data input circuit 26.

The data input circuit 26 comprises an inverter 27 and MOS transistors Q8 to Q12. An output terminal of the inverter 27 to which data $\overline{\text{Din}}$ is supplied is connected to the gate of the MOS transistor Q8 and one end of the n-channel MOS transistor Q9. The other end of the MOS transistor Q9 is connected to the gate of the p-channel MOS transistor Q10, and the gate thereof is connected to the power supply terminal 17c to which the operating power supply voltage Vcc is supplid. The MOS transistors Q10 and Q8 are connected in series between a high voltage power supply terminal 18d to which the high voltage power supply voltage Vpp is supplied and the ground Vss. The p-channel MOS transistor Q11 is connected between the gate of the MOS transistor Q10 and a high voltage power supply terminal 18e to which the high voltage power supply voltage Vpp is supplied. The gate of the MOS transistor Q11 is connected to a node between the MOS transistors Q10 and Q8. The node between the MOS transistors Q10 and Q8 is also connected to the gate of the n-channel MOS transistor Q12. One end of the MOS transistor Q12 is connected to a high voltage power supply terminal 18f to which the high voltage power supply voltage Vpp is supplied, and the other end thereof is connected to the memory cells MC1, MC2, ..., MCn.

Operation of the device will be described hereinafter. Note that the write control signal $\overline{PGM}$ is at level "0" in the data write mode and at level "1" in the data read mode, and the data $\overline{Din}$ is at level "0" in the write mode and at level "1" in the non-write mode.

Now, in the data read mode, when the write control signal $\overline{PGM}$ is at level "1", the MOS transistor Q4 is ON and the MOS transistor Q3 is OFF. Thus, the MOS transistor Q6 is OFF and the MOS transistor Q5 is ON. Since the MOS transistor Q7 is turned on when the write control signal $\overline{PGM}$ is at level "1", the power supply voltage Vcc is selected by the switching circuit 23, and the output from the switching circuit 23 is supplied to the X and Y decoders 24 and 25. In response to the outputs from the X and Y decoders 24 and 25, one memory cell MCx (x = 1, 2, ..., n) is selected, thereby performing a read operation.

In the data write mode, the write control signal $\overline{PGM}$ is at level "0", the MOS transistor Q3 is ON and the MOS transistor Q4 is OFF. Thus, the MOS transistor Q6 is ON, and the MOS transistor Q5 is OFF. At this time, since the MOS transistor Q7 is turned off when the write control signal $\overline{PGM}$ is at level "0", the switching circuit 23 selects the high voltage power supply Vpp. The output from the switching circuit 23 is supplied to the X and Y decoders 24 and 25. In this case, when the data $\overline{Din}$ is at level "0", the MOS transistor Q8 is ON and the MOS transistor Q10 is OFF. The MOS transistor Q12 is OFF, and the MOS transistor Q11 is ON. Therefore, even when the MOS transistor QSx for selecting the memory cell MCx is turned on, no voltage is applied to the drain of the floating gate MOS transistor QMx, but a high voltage is applied only to the gate thereof. Thus, "1" is written in the memory cell MCx. When the data $\overline{Din}$ is at level "1", the MOS transistor Q10 is ON, and the MOS transistor Q8 is OFF. Thus, the MOS transistor Q12 is ON, and the MOS transistor Q11 is OFF. Therefore, the high voltage Vpp is applied between the drain and gate of the floating gate MOS transistor QMx of the selected memory cell MCx so as to inject electrons in its floating gate, thus writing "0" in the memory cell MCx. At this time, if a surge voltage is applied to the high voltage power supply terminals 18a to 18f to which the high voltage power supply voltage Vpp is supplied, the gate insulating film of the MOS transistor with an LDD structure easily breaks down for the same reason as explained with reference to Fig. 1. Generally, since an n-channel MOS transistor has a lower avalanche breakdown voltage than that of a p-channel MOS transistor, the gate insulating film of the n-channel MOS transistor breaks down before that of the latter.

Fig. 4 is a sectional view showing an arrangement of the protective transistor Q1 described above. $n^+$-type impurity diffusion regions 29a and 29b respectively serving as a source S and a drain D are formed in a major surface region of a p-type semiconductor substrate 28 and are spaced by a predetermined distance. These impurity diffusion regions 29a and 29b can be simultaneously formed with the $n^+$-type impurity diffusion regions (e.g., the $n^+$-type impurity diffusion regions 12a and 12b in Fig. 1) of the MOS transistors having the LDD structure which constitute the write circuit 16. Therefore, an impurity concentration of the impurity diffusion regions 29a and 29b is the same as that of the $n^+$-type impurity diffusion regions 12a and 12b in the MOS transistor with an LDD structure, e.g., $1 \times 10^{20}$ cm$^{-3}$. An $n^-$-type impurity diffusion region 30 is formed between the $n^+$-type impurity diffusion regions 29a and 29b so that one end of the region 30 contacts the region 29b. The $n^-$-type impurity diffusion region 30 can be simultaneously formed with the $n^-$-type impurity diffusion regions 13a and 13b. An impurity concentration of the $n^-$-type impurity diffusion region 30 is the same as that of the $n^-$-type impurity diffusion regions 13a and 13b in the MOS transistor with an LDD structure, e.g., $1 \times 10^{17}$ cm$^{-3}$ to $1 \times 10^{18}$ cm$^{-3}$. A gate insulating film 31, e.g., a silicon oxide film of a thickness of 500 Å is formed on a major surface of the semiconductor substrate 28 between the impurity diffusion regions 29a and 30. A gate electrode 32 is formed on the gate insulating film 31. The gate insulating film 31 and the gate electrode 32 are formed in the same step as that of the gate insulating film 14 and the gate electrode 15 of the MOS transistor of the LDD structure in Fig. 1. A high voltage power supply terminal 18 to which the high voltage power supply voltage Vpp is supplied is connected to the $n^+$-type impurity diffusion region 29b as the drain D. The gate electrode 32 and the $n^+$-type impurity diffusion region 29a as the source S are connected to ground Vss.

Operation of the above transistor will be described hereinafter. When a surge voltage is applied to the high voltage power supply terminal 18, an avalanche breakdown occurs in an interface B between the major surface of the semiconductor substrate and the $n^-$-type impurity diffusion region 30, thus generating electron-hole pairs. Because of the relationship between voltages applied to the source S, the drain D and the gate G, electrons are absorbed in the drain D side (indicated by arrow 33), and holes flow toward the substrate (indicated by arrow 34), thereby generating a so-called substrate current. Because of the substrate current, the p-type semiconductor substrate 28 near the source S (the $n^+$-type impurity diffusion region 29a) is forward-biased. Thus, a parasitic bipolar transistor in which the $n^+$-type impurity diffusion region 29b (drain D), the $n^+$-type impurity diffusion region 29a (source S) and the p-type semiconductor substrate 28 respectively serve as a collector, an emitter and a base is turned on. In this case, since the source S is connected to the ground Vss and the parasitic bipolar transistor has a minimal ON resistance, the surge voltage applied to the high voltage power supply terminal 18 can be quickly discharged. Therefore, a surge withstand voltage of the MOS transistors with an LDD structure which constitute the write circuit 16 can be improved.

Note that the present invention is not limited to the embodiment described above. If an avalanche breakdown voltage is kept substantially the same as that of the MOS transistor with an LDD structure, a protective parasitic bipolar transistor can be formed between other impurity diffusion regions.

Fig. 5 shows a structure of a parasitic bipolar transistor QB which is constituted by the semiconductor substrate 28 and one of the source S and the drain D of each of the two adjacent MOS transistors isolated by a field oxide film 35. In Fig. 5, the parasitic bipolar transistor QB has an $n^+$-type impurity diffusion region 36 (the source S) as an emitter, an $n^+$-type impurity diffusion region 37 (the drain D) as a collector and the p-type semiconductor substrate 28 as a base. With this structure, the same operation as that in the above embodiment can be performed and the same effect can be obtained. Alternatively, the same effect can be obtained when an aluminum field transistor or a polysilicon field transistor is used.

Fig. 6 shows another embodiment of the present invention, i.e., a structure where a protective transistor is formed in a CMOS circuit in which a p-type well region 39 is formed in an n-type semiconductor substrate 38. An $n^+$-type impurity diffusion region 40 formed in the p-type well region 39 is connected to a high voltage power supply terminal 18 to which a high voltage power supply voltage Vpp is supplied. $p^+$-type impurity diffusion regions 41a and 41b which are formed in the p-type well region 39 are connected to the ground Vss. In this case, the $n^+$-type impurity diffusion region 40, the well region 39 and the semiconductor substrate 38 respectively serve as an emitter, a base and a collector of a parasitic bipolar transistor QB. Note that reference symbol Rw denotes a base resistance (the resistance of the well region 39).

With this structure, the same effect as in the above embodiments can be obtained. If a p-channel MOS transistor breaks down before an n-channel MOS transistor, a conductivity type of the $n^+$-type impurity diffusion region 40 in Fig. 6 is changed to $p^+$-type, and that of the $p^+$-type impurity diffusion regions 41a and 41b in Fig. 6 is changed to $n^+$-type. Thus, a parasitic bipolar transistor in which the semiconductor substrate (n-type) 38, the well region (p-type) and the $p^+$-type impurity diffusion region 40 respectively serve as a collector, a base and an emitter can be formed.

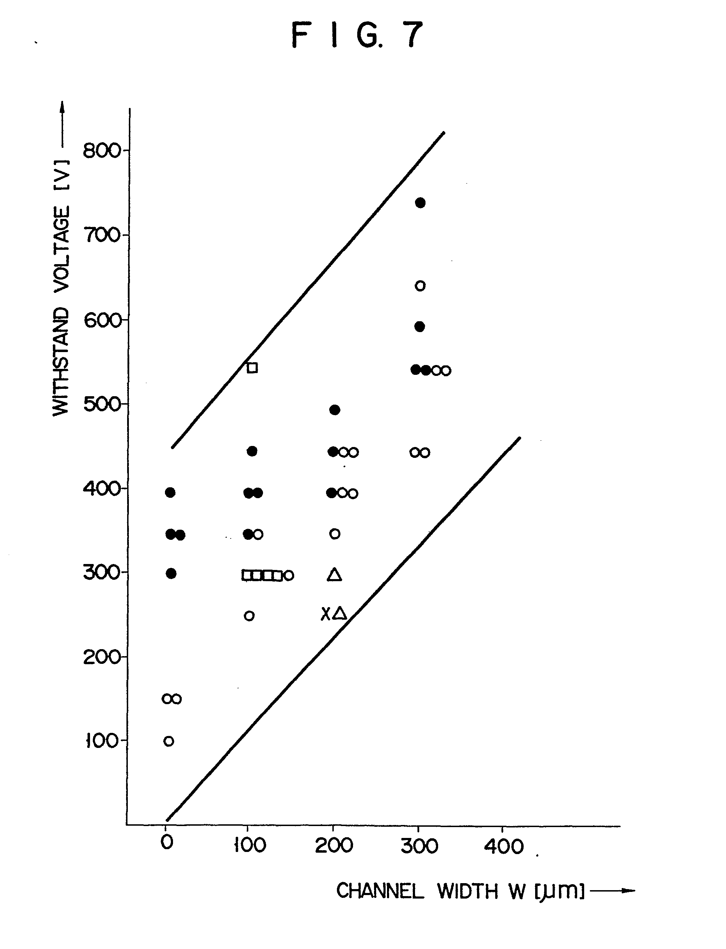

Fig. 7 is a graph showing measurements of a withstand voltage as a function of a channel width of a protective transistor. The protective transistor is formed in such a manner that an aluminum gate is formed in the transistor shown in Fig. 5 so as to form an aluminum field transistor therefor. Note that a channel length L is a constant value, i.e., 4 μm. In this case, the aluminum gate is grounded, a 200 pF capacitor is charged with a predetermined voltage, and an electric charge of this capacitor is applied to a high voltage power supply terminal 18 as a surge voltage. In Fig. 7, reference symbols ● , ×, Δ , ▢ and ○ respectively indicate different lot numbers. When no protective transistor is provided, a channel width W = 0 μm, and the withstand voltage is distributed within a wide range between 100 to 550 V. On the other hand, when a protective transistor is provided, the withstand voltage can be improved in accordance with an increase in the channel width W thereof. For example, in order to obtain a withstand voltage of 300 V, a protective transistor having a channel width of 250 µm or more (when the channel length L is 4 µm) can be formed.

Note that in the above embodiments, protection of the MOS transistor with an LDD structure in the EPROM has been described. However, the present invention is effective for protecting a ROM except for a non-volatile memory such as an $E^2PROM$; a dynamic RAM; a static RAM; and a power supply system or a data output system of a microprocessor and the like from a surge voltage. In micropatterned devices (more specifically, devices having MOS transistors whose polysilicon gate width is 1.5 µm or less), the above LDD structure is very important to cause a power supply voltage for the IC to be decreased to 5 V, and the present invention can be applied to all micropatterned semiconductor integrated circuit devices having the LDD structure.

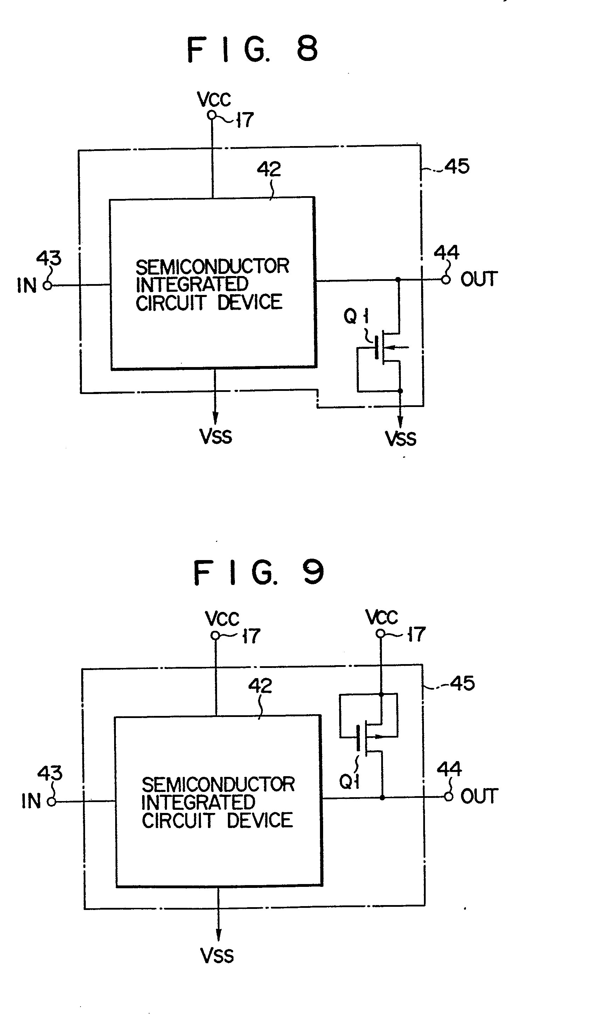

In the above embodiments, the protective transistor is provided between the ground Vss and the high voltage power supply terminal 18 to which the high voltage power supply voltage Vpp is supplied. However, in a circuit in which a surge voltage is easily applied from an output terminal side, a protective transistor can be provided between the output terminal and the ground. Referring to Fig. 8, a semiconductor integrated circuit 42 having MOS transistors with an LDD structure is operated by applying the power supply voltages Vcc and Vss. An input signal IN from an input terminal 43 is supplied to the semiconductor integrated circuit 42 so as to obtain an output signal OUT from an output terminal 44. A protective MOS transistor Q1 is connected between the output terminal 44 and the ground Vss, and the gate thereof is connected to the ground Vss.

With this structure, a surge voltage applied to the output terminal 44 can be discharged to the ground Vss in the same manner as in the circuit shown in Fig. 2. Therefore, the surge withstand voltage of the MOS transistors with an LDD structure in the semiconductor integrated circuit device can be improved. The protective MOS transistor Q1 can be formed on the same semiconductor substrate 45 as the semiconductor integrated circuit 42, and the structure thereof can be the same as those shown in Figs. 4 to 6.

When the semiconductor integrated circuit 42 consists of p-channel MOS transistors whose breakdown voltage is lower than that of n-channel MOS transistors, the MOS transistor Q1 can be connected between the output terminal 44 and the power supply terminal 17 to which the operating power supply voltage Vcc is supplied, as shown in Fig. 9. The gate and back gate of the MOS transistor Q1 are connected to the power supply terminal 17. With this structure, a surge voltage applied to the output terminal 44 can be discharged to the ground Vss in the same manner as in the circuit of Fig. 2. Therefore, the surge withstand voltage of the p-channel MOS transistors with an LDD structure in the semiconductor integrated circuit 42 can be improved.

Claims:

1. A semiconductor integrated circuit device including a MOS transistor with an LDD structure, comprising a semiconductor substrate (19, 28, 38) of a first conductivity type having a major surface, and a semiconductor integrated circuit (16) which is formed on a major surface region of said semiconductor substrate (19, 28, 38), includes the MOS transistor with an LDD structure and has a power supply terminal (18) and a ground point (Vss), characterized by comprising a protective MOS transistor (Q1) having a parasitic bipolar transistor (QB), which is formed on the major surface region of said semiconductor substrate (19, 28, 38), has a drain (D) connected to said power supply terminal (18), a source (S) connected to said ground point (Vss) and a gate (G), and discharges to said ground point (Vss) an electric charge generated in said semiconductor substrate (19, 28, 38) by application of a surge voltage to said power supply terminal (18).

2. A semiconductor integrated circuit device including a MOS transistor with an LDD structure according to claim 1, characterized in that said protective MOS transistor (Q1) comprises a first impurity diffusion region (29a) of a second conductivity type which is formed in the major surface region of said semiconductor substrate (19, 28) of the first conductivity type and is connected to said ground point (Vss), a second impurity diffusion region (29b) of the second conductivity type which is formed to be separated from said first impurity diffusion region (29a) by a predetermined distance and is connected to said power supply terminal (18), a third impurity diffusion region (30) of the second conductivity type having a lower impurity concentration than that of said first and second impurity diffusion regions (29a, 29b) and contacting said second impurity diffusion region (29b), a gate insulating film (31) formed on the major surface of said semiconductor substrate (19, 28) between said first and third impurity diffusion regions (29a, 30), and a gate electrode (32) which is formed on said gate insulating film (31) and is connected to said ground point (Vss); and said parasitic bipolar transistor (QB) has said first impurity diffusion region (29a) as an emitter, said semiconductor substrate (19, 28) as a base and said second impurity diffusion region (29b) as a collector.

3. A semiconductor integrated circuit device including a MOS transistor with an LDD structure according to claim 1, characterized in that said protective MOS transistor (Q1) comprises a field oxide film (35) formed on the major surface of said semiconductor substrate (19, 28) of the first conductivity type, and first and second impurity diffusion regions (36, 37) of the second conductivity type which are formed in the major surface region of said semiconductor substrate (19, 28) and are isolated by said field oxide film (35), said first impurity diffusion region (36) being connected to said ground point (Vss), said second impurity diffusion region (37) being connected to said power supply terminal (18), and said parasitic bipolar transistor (QB) having said first impurity diffusion region (36) as an emitter, said semiconductor substrate (19, 28) as a base and said second impurity diffusion region (37) as a collector.

4. A semiconductor integrated circuit device including a MOS transistor with an LDD structure according to claim 1, characterized in that said protective MOS transistor (Q1) comprises a well region (39) of the second conductivity type formed on the major surface region of said semiconductor substrate (19, 38) of the first conductivity type, a first impurity diffusion region (40) of the first conductivity type which is formed in said well region (39) and is connected to said power supply terminal (18), and a second impurity diffusion region (41a, 41b) of the second conductivity type which has a higher impurity concentration than that of said well region (39), is formed in said well region (39) and is connected to said ground point (Vss); and said parasitic bipolar transistor (QB) has said first impurity diffusion region (40) as an emitter, said well region (39) as a base and said semiconductor substrate (19, 38) as a collector.

5. A semiconductor integrated circuit device including a MOS transistor with an LDD structure, comprising a semiconductor substrate (28, 38, 45) of a first conductivity type having a major surface, and a semiconductor integrated circuit (16) which is formed on a major surface region of said semiconductor substrate (28, 38, 45), includes the MOS transistor with an LDD structure, and has an output terminal (44) and a ground point (Vss), characterized by comprising a protective MOS transistor (Q1) having a parasitic bipolar transistor (QB), which is formed on the major surface region of said semiconductor substrate (28, 38, 45), has a drain (D) connected to said output terminal (44), a source (S) connected to said ground point (Vss) and a gate (G), and discharges to said ground point (Vss) an electric charge generated in said semiconductor substrate (28, 38, 45) by application of a surge voltage to said output terminal (44).

6. A semiconductor integrated circuit device including a MOS transistor with an LDD structure according to claim 5, characterized in that said protective MOS transistor (Q1) comprises a first impurity diffusion region (29a) of a second conductivity type which is formed in the major surface region of said semiconductor substrate (28, 45) of the first conductivity type and is connected to said ground point (Vss), a second impurity diffusion region (29b) of the second conductivity type which is formed to be separated from said first impurity diffusion region (29a) by a predetermined distance and is connected to said output terminal (44), a third impurity diffusion region (30) of the second conductivity type having a lower impurity concentration than that of said first and second impurity diffusion regions (29a, 29b) and contacting said second impurity diffusion region (29b), a gate insulating film (31) formed on the major surface of said semiconductor substrate (19, 28) between said first and third impurity diffusion regions (29a, 30), and a gate electrode (32) which is formed on said gate insulating film (31) and is connected to said ground point (Vss); and said parasitic bipolar transistor (QB) has said first impurity diffusion region (29a) as an emitter, said semiconductor substrate (19, 28) as a base and said second impurity diffusion region (29b) as a collector.

7. A semiconductor integrated circuit device including a MOS transistor with an LDD structure according to claim 5, characterized in that said protective MOS transistor (Q1) comprises a field oxide film (35) formed on the major surface of said semiconductor substrate (28, 45) of the first conductivity type, and first and second impurity diffusion regions (36, 37) of the second conductivity type which are formed in the major surface region of said semiconductor substrate (28, 45) and are isolated by said field oxide film (35), said first impurity diffusion region (36) being connected to said ground point (Vss), said second impurity diffusion region (37) being connected to said output terminal (44), and said parasitic bipolar transistor (QB) having said first impurity diffusion region (36) as an emitter, said semiconductor substrate (28, 45) as a base and said second impurity diffusion region (37) as a collector.

8. A semiconductor integrated circuit device including a MOS transistor with an LDD structure according to claim 5, characterized in that said protective MOS transistor (Q1) comprises a well region (39) of the second conductivity type formed on the major surface region of said semiconductor substrate (38, 45) of the first conductivity type, a first impurity diffusion region (40) of the first conductivity type which is formed in said well region (39) and is connected to said output terminal (44), and a second impurity diffusion region (41a, 41b) of the second conductivity type which has a higher impurity concentration than that of said well region (39), is formed in said well region (39) and is connected to said ground point (Vss); said parasitic bipolar transistor (QB) has said first impurity diffusion region (40) as an emitter, said well region (39) as a base and said semiconductor substrate (38, 45) as a collector.

# F I G. 1

0161446

# F I G. 2

Vpp 18   Vcc 17

Q1

Vss

WRITE CIRCUIT

16

19

Vss

# F I G. 4

Vpp 18

Vss

S

G

32
31

N⁺   B   ⊖   N⁻   N⁺
29a      33   30   29b

28

QB

34

Rs

P-sub

0161446

# F I G. 3

# F I G. 5

# F I G. 6

0161446

# F I G. 7

0161446

# F I G. 8

VCC ⟳—17

43
IN ⟳—

| 42 |
| SEMICONDUCTOR INTEGRATED CIRCUIT DEVICE |

45

44
⟳ OUT

Q1

VSS

VSS

# F I G. 9

VCC ⟳—17

VCC ⟳—17

42
SEMICONDUCTOR INTEGRATED CIRCUIT DEVICE

45

43
IN ⟳—

Q1

44
⟳ OUT

VSS